# EUROPEAN PATENT SPECIFICATION

(11) **EP 3 225 964 B1**
(45) Date of publication and mention of the grant of the patent: **18.09.2019**
(21) Application number: 15863885.8
(22) Date of filing: 16.11.2015
(51) Int. Cl.: G01L 19/00, G01L 9/00, H01L 29/84, G01L 19/06, G01L 19/14

(54) **SEMICONDUCTOR SENSOR DEVICE**
HALBLEITERSENSORVORRICHTUNG
DISPOSITIF DE CAPTEUR SEMI-CONDUCTEUR

(30) Priority: 28.11.2014 JP 2014242203
(43) Date of publication of application: 04.10.2017
(73) Proprietor: Mitsumi Electric Co., Ltd., Tama-shi, Tokyo 206-8567 (JP)
(72) Inventor: YAMAGUCHI, Shinya, Tama-Shi Tokyo 206-8567 (JP); SUGANUMATA, Masayuki, Tama-Shi Tokyo 206-8567 (JP); AOKI, Hiroshi, Tama-Shi Tokyo 206-8567 (JP); KURIBAYASHI, Satoshi, Tama-Shi Tokyo 206-8567 (JP)
(74) Representative: Regimbeau
(86) International application number: PCT/JP2015/082117
(87) International publication number: WO 2016/084641

(56) References cited:
- WO-A1-2014/127938
- JP-A- H0 943 084
- JP-A- H10 160 604
- JP-A- 2003 254 849
- JP-A- 2003 254 849

## Description

### BACKGROUND OF THE INVENTION

### 1. Field of the Invention

The present invention relates to a semiconductor sensor device.

### 2. Description of the Related Art

Conventionally, semiconductor sensor devices that detect pressure have been known. Such a semiconductor sensor device has, for example, a glass base joined to a semiconductor sensor element to improve the rigidity in order to reduce an influence of stress. In this structure, external force does not propagate to the semiconductor sensor element, and hence, the influence of the external force is checked considerably. However, the production man-hours of the semiconductor sensor device increase, and the cost becomes higher. Also, degradation of basic characteristics has been confirmed by reliability testing, such as high-temperature, high-humidity testing.

Also, in a semiconductor sensor device, it is often the case that parts are mounted by adhesive resin. In such a case, if multiple bonded parts by the adhesive resin exist on a path of a pressure medium, the number of locations through which the pressure medium may possibly leak increases up to the number of the bonded parts, which reduces the reliability. In order to solve this problem, a structure has been proposed in which a semiconductor sensor element is directly mounted on a metal or molding resin part that forms a pressure introducing part (see, for example, Patent document 1). In this structure, the bonded part is limited to just one location between the pressure introducing part and the semiconductor sensor element, so as to minimize locations where the pressure medium may possibly leak, and to improve the reliability.

### [Related-Art Documents]

### [Patent Documents]

### [Patent Document 1] Japanese Unexamined Patent Application Publication No. 2000-171319

However, concerns exist in the above structure in terms of adhesiveness for joining the semiconductor sensor element; reduction of the adhesion strength due to the remainder of a release agent of a molding resin part; unhardened resin; and the like. Also, another concern exists that mounting the semiconductor sensor element on the pressure introducing part may allow stress to propagate directly to the semiconductor sensor element when being attached to a product. These factors make it difficult to secure reliability with the above structure.

Also, the above structure makes it difficult to manufacture a product by a mounter that is normally used, and a dedicated machine needs to be introduced for forming wires to the semiconductor sensor element, so that the semiconductor sensor element and lead frames can be heated at the same time. This makes it difficult to reduce the manufacturing cost with the above structure. Other pressure sensors are also disclosed in JP 2003 254849 A and WO 2014/127938 A1.

In view of the above, an embodiment of the present invention has an object to provide a semiconductor sensor device having a secured reliability and a reduced manufacturing cost.

Further state of the art pressure sensors are known from JP2003-254849A and WO2014/127938 A1.

### SUMMARY OF THE INVENTION

According to the invention, the semiconductor sensor device as defined in appended claim 1 and the corresponding dependent claims is provided.

The present application also discloses a semiconductor sensor device (1, 1A) including a substrate (10); a semiconductor sensor element (20) mounted on one side of the substrate (10), to detect pressure of a pressure medium; a protection member (70) mounted on the one side of the substrate (10), to protect the semiconductor sensor element (20); and a pressure medium introduction member (80) mounted on another side of the substrate (10), to introduce a pressure medium into the semiconductor sensor element (20) via a penetration hole (10x) provided in the substrate (10), wherein the protection member (70) and the pressure medium introduction member (80) are joined in a state of having the substrate (10) interposed in-between.

Note that the reference codes in parentheses are attached to make the description easily understandable; they are just examples, and not limited to aspects illustrated in the drawings.

According to the invention, it is possible to provide a semiconductor sensor device having a secured reliability and a reduced manufacturing cost.

### BRIEF DESCRIPTION OF THE DRAWINGS

FIG. 1A is a front view illustrating a semiconductor sensor device according to a first embodiment;
FIG. 1B is a perspective view illustrating a semiconductor sensor device according to the first embodiment;
FIG. 2A is a plan view illustrating a semiconductor sensor device according to the first embodiment;
FIG. 2B is a bottom view illustrating a semiconductor sensor device according to the first embodiment;
FIG. 3A is a cross-sectional view illustrating a semiconductor sensor device according to the first embodiment;
FIG. 3B is an enlarged view of a part of FIG. 3A;
FIG. 4 is a cross-sectional view illustrating a semiconductor sensor device according to the first embodiment;
FIG. 5A is a diagram illustrating a manufacturing process of a semiconductor sensor device according to the first embodiment;
FIG. 5B is another diagram illustrating a manufacturing process of a semiconductor sensor device according to the first embodiment;
FIG. 6A is another diagram illustrating a manufacturing process of a semiconductor sensor device according to the first embodiment;
FIG. 6B is yet another diagram illustrating a manufacturing process of a semiconductor sensor device according to the first embodiment;
FIG. 7A is yet another diagram illustrating a manufacturing process of a semiconductor sensor device according to the first embodiment;
FIG. 7B is yet another diagram illustrating a manufacturing process of a semiconductor sensor device according to the first embodiment;
FIG. 8A is yet another diagram illustrating a manufacturing process of a semiconductor sensor device according to the first embodiment;
FIG. 8B is yet another diagram illustrating a manufacturing process of a semiconductor sensor device according to the first embodiment;
FIG. 9A is yet another diagram illustrating a manufacturing process of a semiconductor sensor device according to the first embodiment;
FIG. 9B is yet another diagram illustrating a manufacturing process of a semiconductor sensor device according to the first embodiment;
FIG. 10A is yet another diagram illustrating a manufacturing process of a semiconductor sensor device according to the first embodiment;
FIG. 10B is yet another diagram illustrating a manufacturing process of a semiconductor sensor device according to the first embodiment;
FIG. 11A is yet another diagram illustrating a manufacturing process of a semiconductor sensor device according to the first embodiment;
FIG. 11B is yet another diagram illustrating a manufacturing process of a semiconductor sensor device according to the first embodiment;
FIG. 12A is yet another diagram illustrating a manufacturing process of a semiconductor sensor device according to the first embodiment;
FIG. 12B is yet another diagram illustrating a manufacturing process of a semiconductor sensor device according to the first embodiment;
FIG. 13A is yet another diagram illustrating a manufacturing process of a semiconductor sensor device according to the first embodiment;
FIG. 13B is yet another diagram illustrating a manufacturing process of a semiconductor sensor device according to the first embodiment;
FIG. 14 is yet another diagram illustrating a manufacturing process of a semiconductor sensor device according to the first embodiment; and
FIG. 15 is a cross-sectional view illustrating a semiconductor sensor device according to a modified example of the first embodiment.

### DETAILED DESCRIPTION OF THE PREFERRED EMBODIMENTS

In the following, embodiments of the present invention will be described with reference to the drawings . In the drawings, the same parts are assigned the same codes; accordingly, duplicated description may be omitted.

### <First embodiment>

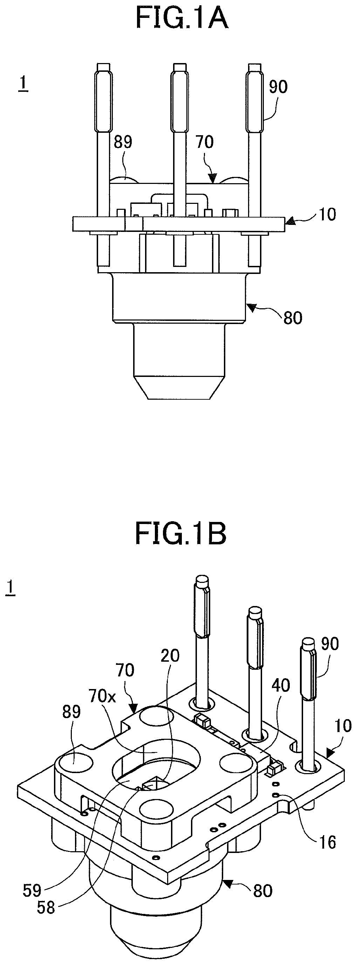

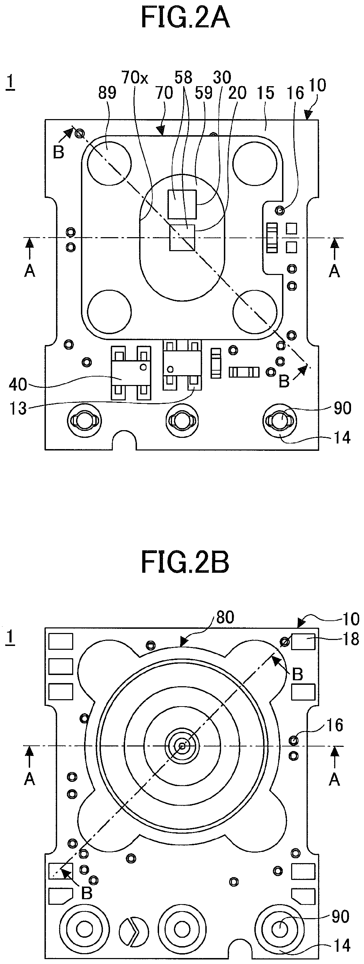

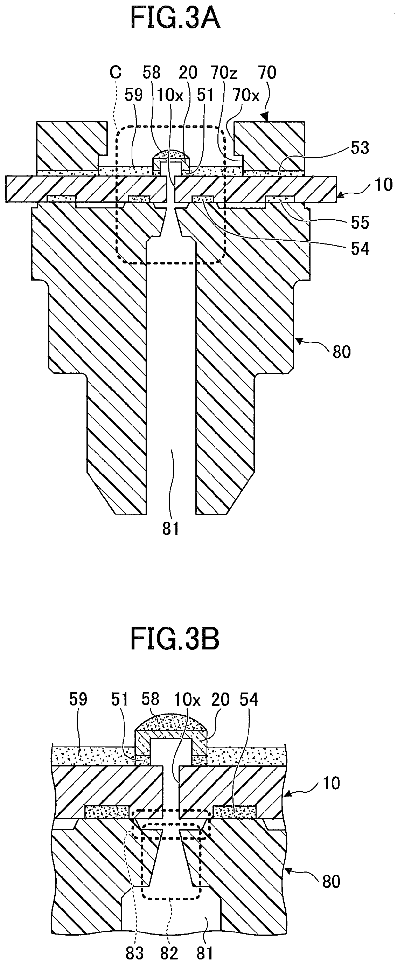

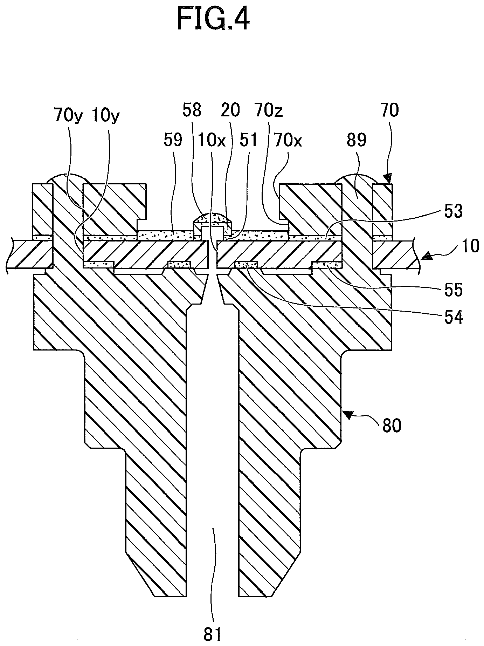

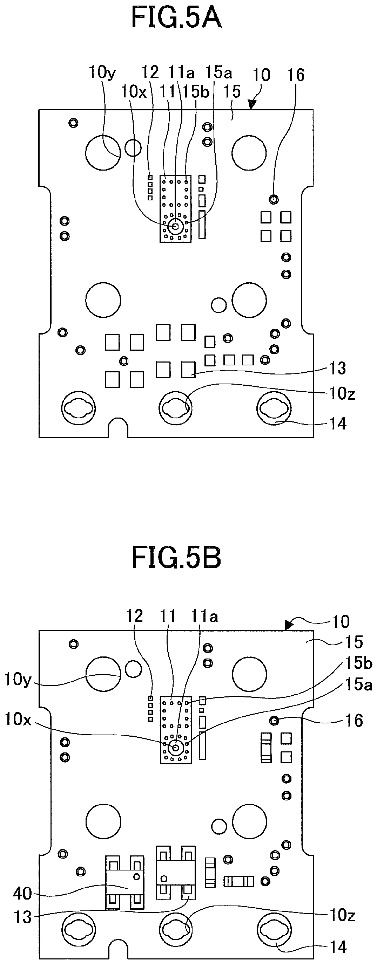

FIG. 1A to FIG. 4 are diagrams illustrating a semiconductor sensor device according to the first embodiment. Note that FIG. 1A is a front view; FIG. 1B is a perspective view; FIG. 2A is a plan view; FIG. 2B is a bottom view; FIG. 3A is a cross-sectional view along a line A-A in FIG. 2A and FIG. 2B; FIG. 3B is an enlarged view of a part C in FIG. 3A; and FIG. 4 is a cross-sectional view along a line B-B line in FIG. 2A and FIG. 2B. Also, FIG. 5A to FIG. 14 are diagrams illustrating manufacturing processes of a semiconductor sensor device according to the first embodiment.

### [Structure of semiconductor sensor device according to first embodiment]

First, the structure of a semiconductor sensor device 1 will be described according to the first embodiment with reference to FIG. 1A - FIG. 5B. As illustrated in FIG. 1A to FIG. 5B, the semiconductor sensor device 1 has, as main parts, a substrate 10, a cylinder 70, a nozzle 80, and an external terminal 90. The cylinder 70 and the nozzle 80 are joined in a state of having the substrate 10 interposed in-between.

Note that in the present embodiment, as a matter of convenience, a side of the semiconductor sensor device 1 facing the cylinder 70 will be referred to as the upper side or the one side, and the other side facing the nozzle 80 will be referred to as the lower side or the other side. Also, a surface of each part facing the cylinder 70 will be referred to as the upper surface or the one surface, and the other surface facing the nozzle 80 will be referred to as the lower surface or the other surface. However, the semiconductor sensor device 1 can be used in a state where it is arranged upside down, or can be tilted at any angle. Also, a "plan view" means viewing an object in the direction of the normal to the upper surface of the substrate 10, and a "planar shape" means a shape of an object when viewing in the direction of the normal to the upper surface of the substrate 10.

In the semiconductor sensor device 1, the planar shape of the substrate 10 may be approximately rectangular; however, the shape may also be any shape other than the approximately rectangular shape. Also, notches and the like may be provided on the outer edge part of the substrate 10 if necessary. As the substrate 10, what is called a glass epoxy substrate, a ceramic substrate, a silicon substrate, or the like may be used.

An element installation area 11, bonding pads 12, part mounting pads 13, external terminal mounting pads 14, a solder resist 15, through holes 16, a pressure medium introduction hole 10x, positioning holes 10y, external terminal insertion holes 10z, and the like are formed on the substrate 10. With respect to the element installation area 11, for example, Copper (Cu) is exposed on. Also, with respect to the bonding pads 12, the part mounting pads 13, and the external terminal mounting pads 14, for example, gold (Au) plating formed on the upper surface of copper (Cu) is exposed.

However, gold (Au) plating may also be applied to the surrounding area 11a of the pressure medium introduction hole 10x formed on the element installation area 11. Applying gold (Au) plating to the surrounding area 11a of the pressure medium introduction hole 10x, which is a portion where the substrate 10 and the pressure medium contact, minimizes diffusion of the pressure medium into the substrate 10 and corrosion of copper (Cu) wiring on the substrate 10. Note that although a similar effect can be obtained without gold (Au) plating as long as the copper film is arranged, gold (Au) plating on the copper film makes it more effective.

The part mounting pads 13 of the substrate 10 are provided to mount a mounting part 40. The mounting parts 40 may include a part or all of an IC, a transistor, a resistor, a capacitor, and an inductor, or any other parts.

The solder resist 15 is provided on the upper surface and the lower surface of the substrate 10 such that the element installation area 11, the bonding pads 12, the part mounting pads 13, the external terminal mounting pads 14, and the like are exposed. The solder resist 15 has resist spacers 15a and 15b, which are convex parts selectively formed in the element installation area 11. The resist spacers 15a are bases for installing the semiconductor sensor element 20, selectively provided in an area where the semiconductor sensor element 20 is mounted. Also, the resist spacers 15b are bases for installing a control IC 30, selectively provided in an area where the control IC 30 is mounted.

The semiconductor sensor element 20 is placed on the resist spacers 15a of the element installation area 11, and fixed by an adhesive resin 51. The control IC 30 is placed on the resist spacers 15b, and fixed by an adhesive resin 52. Note that the cylinder 70, which is a protection member to protect the semiconductor sensor element 20 and the like, is fixed on the upper surface of the substrate 10 by an adhesive resin 53, and the semiconductor sensor element 20 and the control IC 30 are arranged in an opening 70x provided in an approximately central part of the cylinder 70.

The semiconductor sensor element 20 is a sensor to detect the pressure of the pressure medium, and has a diaphragm. The diaphragm is a member that constitutes a sensor surface being the upper surface of the semiconductor sensor element 20, and has a function to convert stress generated by the pressure into an electric signal to be detected. The semiconductor sensor element 20 may be an element of a semiconductor deformation gauge scheme that detects deformation of the diaphragm as a change in the resistance; an element of an electrostatic capacitance scheme that detects displacement of the diaphragm as a change in the electrostatic capacitance; or an element that detects pressure by any other detection scheme.

The control IC 30 is an IC to control the semiconductor sensor element 20. The control IC 30 has, for example, a temperature sensor built in, and the control IC 30 executes temperature compensation for a characteristic of the semiconductor sensor element 20. In order to raise the accuracy of the temperature compensation for the characteristic of the semiconductor sensor element 20, the control IC 30 is mounted in the vicinity of the semiconductor sensor element 20.

A device protection gel 58 is provided on the upper surface of the semiconductor sensor element 20 and the upper surface of the control IC 30. Also, in a stepping part 70z formed on the lower part of the inner wall surface of the opening 70x of the cylinder 70, a substrate protection gel 59 is provided so as to cover the upper surface of the substrate 10 in the vicinity of the semiconductor sensor element 20 and the control IC 30. As the device protection gel 58, a silicone gel having a small change of viscoelasticity over a wide temperature range may be used, for example. As the substrate protection gel 59, a fluoride gel having a high reliability may be used, for example. However, the same material may be used for the device protection gel 58 and the substrate protection gel 59.

The nozzle 80 is a pressure medium introduction member to introduce the pressure medium into the semiconductor sensor element 20, and has a cylindrical pressure medium introduction hole 81 provided in an approximately central part. The pressure medium introduction hole 81 (a penetration hole) of the nozzle 80 is continuous with the pressure medium introduction hole 10x (a penetration hole) of the substrate 10, and the pressure medium (for example, gas such as propane gas and utility gas) introduced from the pressure medium introduction hole 81 reaches the diaphragm of the semiconductor sensor element 20 via the pressure medium introduction hole 10x.

Deformation (or displacement) of the diaphragm of the semiconductor sensor element 20) changes depending on the difference between the pressure of the pressure medium introduced from the pressure medium introduction hole 81 of the nozzle 80, and the atmospheric pressure introduced from the opening 70x of the cylinder 70. Therefore, by detecting the amount of deformation (or the amount of displacement) of the diaphragm as the amount of change of a resistance value (or an electrostatic capacitance value), the pressure of the pressure medium introduced from the pressure medium introduction hole 81 can be detected.

In this way, forming a structure in which the pressure medium is received on the lower surface side of the diaphragm of the semiconductor sensor element 20 makes it possible to prevent corrosion that may be generated in resistors, wires, and the like formed on the upper surface side of the diaphragm of the semiconductor sensor element 20. Also, this structure reduces the area where the substrate 10 and the pressure medium contact, and hence, can minimize an influence of the pressure medium on the substrate 10, and can improve the reliability.

Note that as illustrated in FIG. 3B, a flow restriction part 82 to restrict the flow of the pressure medium is provided in the pressure medium introduction hole 81 on the side close to the substrate 10, and a buffer part 83 having a larger cross-sectional area than the flow restriction part 82 is provided closer to the substrate 10. Note that the cross-sectional area of the flow restriction part 82 is maximum at a position of the flow restriction part 82 furthest from the buffer part 83, and gradually decreases at a position in the flow restriction part 82 closer to the buffer part 83.

In other words, along the direction from the far end to the closer end relative to the substrate 10, the pressure medium introduction hole 81 has a first portion (a portion excluding the flow restriction part 82 and the buffer part 83) having a first cross-sectional area; a second portion (the flow restriction part 82) having a second cross-sectional area smaller than the first cross-sectional area; and a third portion (the buffer part 83) having a third cross-sectional area larger than the second cross-sectional area. Namely, the first portion is formed at the position away from the substrate, the third portion is formed at the position close to the substrate, and the second portion is formed between the first portion and the third portion.

The cross-section (transverse section) of each of the first to third portions may be made circular, for example. In this case, the diameter of a part of the pressure medium introduction hole 81 excluding the flow restriction part 82 and the buffer part 83 can be set to about 2 mm, for example. The diameter of the flow restriction part 82 at the end far from the buffer part 83 may be set to about 0.8 mm, and the diameter at the end close to the buffer part 83 may be set to about 0.3 mm, for example. The diameter of the buffer part 83 may be set to about 1.1 mm, for example.

In this way, by having the flow restriction part 82 restrict the flow of the pressure medium, and providing the buffer part 83 having a larger cross-sectional area than the flow restriction part 82 on the side of the flow restriction part 82 closer to the substrate 10, the space formed by the buffer part 83 plays the role of a buffer to absorb pressure propagation. As a consequence, it is possible to protect the semiconductor sensor element 20 against pressure suddenly applied thereto.

Also, pillar-shaped positioning parts 89 (for example, at four places) are provided on the upper surface of the nozzle 80. Each positioning part 89 of the nozzle 80 is inserted into the positioning hole 10y of the substrate 10 and the positioning hole 70y of the cylinder 70 that are continuous, and the tip is projected out of the upper surface of the cylinder 70. The outer edge of the portion of the positioning part 89 projected out of the upper surface of the cylinder 70 is spread in a ring shape around the positioning hole 70y on the upper surface of the cylinder 70 by heat welding, and joined to the upper surface of the cylinder 70.

Note that the substrate 10 and the cylinder 70 are bonded by the adhesive resin 53, and the substrate 10 and the nozzle 80 are bonded by an adhesive resin for sealing 54 and a nozzle adhesive resin 55. Accordingly, the substrate 10, the cylinder 70, and the nozzle 80 are adhered together tightly. Therefore, it is possible to prevent leakage of the pressure medium introduced from the pressure medium introduction hole 81 of the nozzle 80. Moreover, the cylinder 70 and the nozzle 80 are joined by heat welding, having the substrate 10 interposed in-between. In this way, the mechanical strength of the substrate 10, the cylinder 70, and the nozzle 80 can be increased by fixing these parts using the adhesive resins 53, 54, and 55 together with heat welding. That is, it is possible to improve the reliability of the portion where the pressure medium is to be sealed.

Note that the semiconductor sensor device 1 has the semiconductor sensor element 20 mounted on the substrate 10, without directly connecting to an external portion such as the cylinder 70 and the nozzle 80. Therefore, it is possible to prevent stress from propagating from an external portion to the semiconductor sensor element 20 when attaching the semiconductor sensor device 1 to an object to be attached thereto.

Also, instead of using a glass base as has been done conventionally, the semiconductor sensor element 20 is made to have a greater thickness, and mounted on the substrate 10 via the adhesive resin 51 being a low elastic resin. By using a low elastic resin as the adhesive resin 51, it is possible to reduce any effects of external stress and to relax the external stress to the same level as obtained with providing a glass base. Furthermore, this structure does not have a glass base mounted, and hence, can reduce the manufacturing cost.

Note that since the cylinder 70 and the nozzle 80 can be produced by resin molding, the shapes can be changed easily. Therefore, semiconductor sensor devices for various applications can be realized by changing the shapes appropriately.

### [Method for manufacturing of semiconductor sensor device according to first embodiment]

Next, a method for manufacturing the semiconductor sensor device 1 will be described according to the first embodiment with reference to FIG. 5A to FIG. 14. Note that FIG. 5A to FIG. 14 correspond to respective processes included in this method for manufacturing. First, in a process illustrated in FIG. 5A, a substrate 10 is prepared. Then, in a process illustrated in FIG. 5B, mounting parts 40 are mounted on the respective part mounting pads 13 of the substrate 10. Specifically, for example, cream solder is applied to the part mounting pads 13, the mounting parts 40 are placed on the cream solder, and then, the cream solder is melted by reflow or the like, to be solidified afterward. Note that the semiconductor sensor device 1 has all parts mounted on the upper surface or the lower surface of the substrate 10 and not directly mounted on the cylinder 70 or the nozzle 80. Therefore, it is possible to manufacture the semiconductor sensor device 1 easily using an existing mounter.

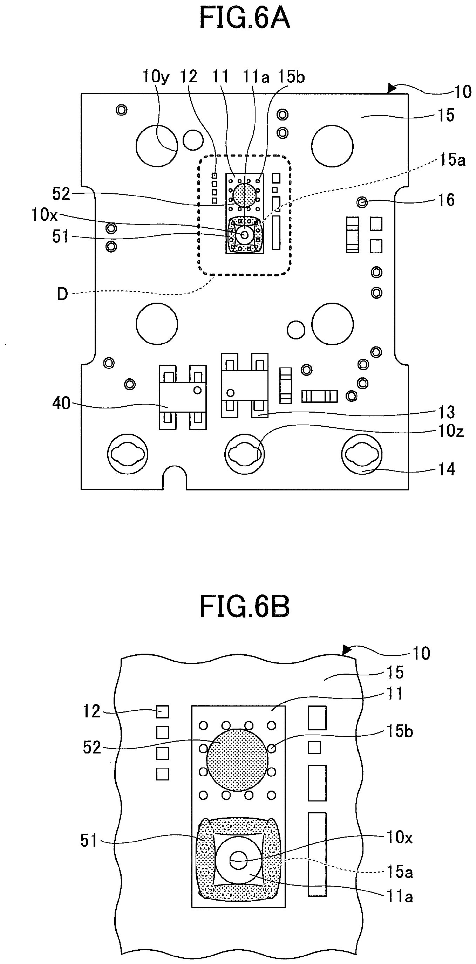

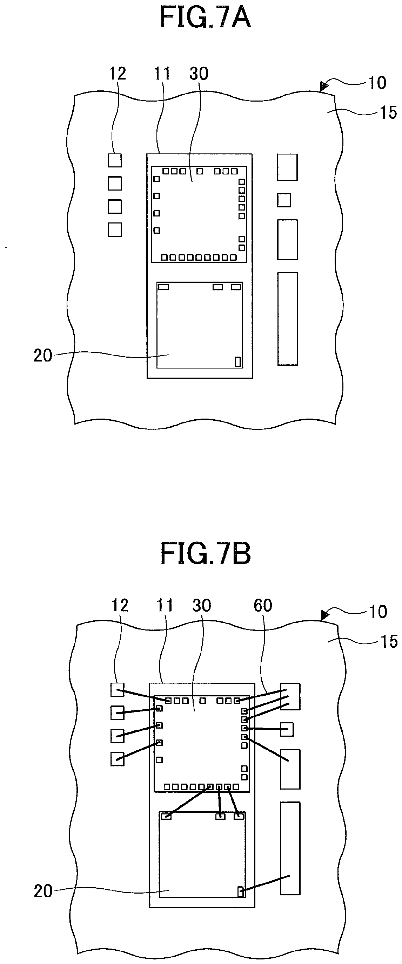

Next, in a process illustrated in FIG. 6A and FIG. 6B, the adhesive resins 51 and 52 are applied to an area where the semiconductor sensor element 20 is to be mounted and an area where the control IC is to be mounted in the element installation area 11. As the adhesive resins 51 and 52, a silicone or the like being a low elastic resin may be used, for example. However, the same resin may be used for the adhesive resins 51 and 52 or different resins may also be used. Note that FIG. 6B is an enlarged view of a part D in FIG. 6A (this is the same for FIG. 7A and FIG. 7B).

Next, in a process illustrated in FIG. 7A, the semiconductor sensor element 20 and the control IC 30 are mounted in the element installation area 11 of the substrate 10. Specifically, for example, the semiconductor sensor element 20 is installed on the resist spacer 15a and the control IC 30 is installed on the resist spacer 15b illustrated in FIG. 6B. Then, the adhesive resins 51 and 52 are hardened by heating or the like, to have the semiconductor sensor element 20 and the control IC 30 mounted on the substrate 10.

Next, in a process illustrated in FIG. 7B, electric connections (wire bonding) are formed between the electrode terminals of the semiconductor sensor element 20 and the bonding pads 12; between the electrode terminals of the control IC 30 and the bonding pads 12; and between the electrode terminals of the semiconductor sensor element 20 and the electrode terminals of the control IC 30, via metal wires 60. As the metal wires 60, gold wires, copper wires, or the like may be used, for example. Note that since the resist spacer 15a is arranged below the semiconductor sensor element 20 and the resist spacer 15b is arranged below the control IC 30, the wire bonding can be executed stably.

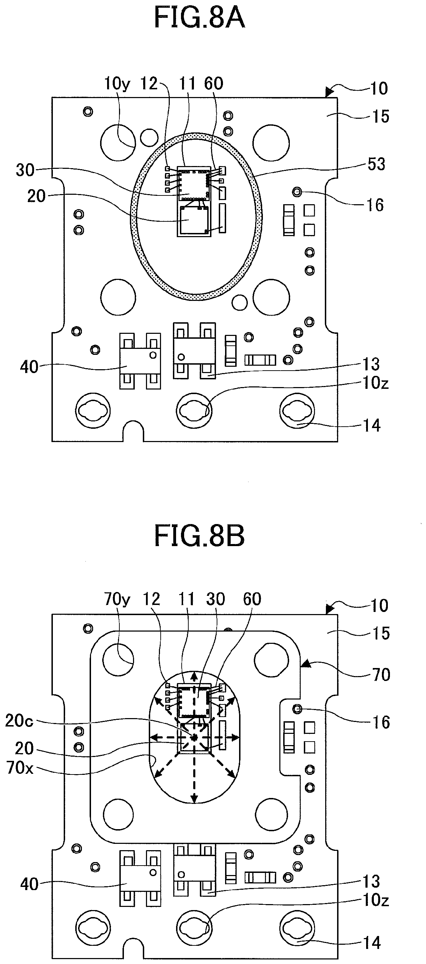

Next, in a process illustrated in FIG. 8A, the adhesive resin 53 is applied so as to surround the vicinity of the element installation area 11 and the bonding pads 12.

Next, in a process illustrated in FIG. 8B, the cylinder 70 is mounted on the upper surface of the substrate 10. Specifically, for example, the cylinder 70 is placed on the adhesive resin 53 illustrated in FIG. 8A, and heated to harden the adhesive resin 53. Note that an opening 70x is provided at an approximately central part of the cylinder 70 to expose the bonding pads 12, the semiconductor sensor element 20, the control IC 30, and the metal wires 60. Also, the positioning holes 70y are provided on the outer edge part of the cylinder 70, which is continuous with the positioning holes 10y of the substrate 10.

Note that in the plan view, it is preferable that collinear distance pairs from the center 20c of the semiconductor sensor element 20 to the inner wall surface of the opening 70x (dashed line arrows in FIG. 8B) have a relationship of point symmetry. This is because mounting the semiconductor sensor element 20 at the center of the opening 70x can minimize an influence of stress generated when the substrate 10 is bent.

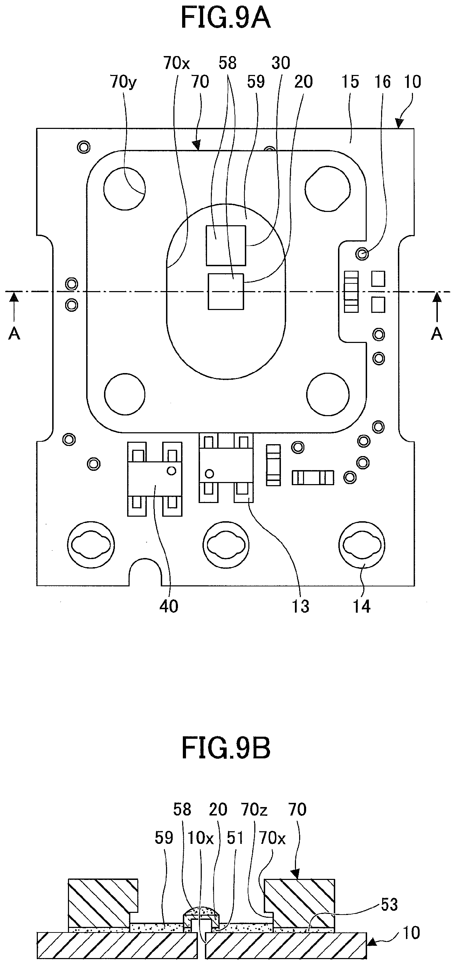

Next, in a process illustrated in FIG. 9A and FIG. 9B, the device protection gel 58 is applied to the upper surface of the semiconductor sensor element 20 and the upper surface of the control IC 30. Then, after having the device protection gel 58 heated to be hardened, the substrate protection gel 59 is applied such that the upper surface of the substrate 10 in the vicinity of the semiconductor sensor element 20 and the control IC 30 is covered within the stepping part 70z formed in the lower part of the inner wall surface of the opening 70x of the cylinder 70. Then, the substrate protection gel 59 is heated to be hardened. As the device protection gel 58, a silicone gel having a small change of viscoelasticity over a wide temperature range may be used, for example. As the substrate protection gel 59, a fluoride gel having a high reliability may be used, for example. Note that FIG. 9B is a cross-sectional view along the line A-A in FIG. 9A.

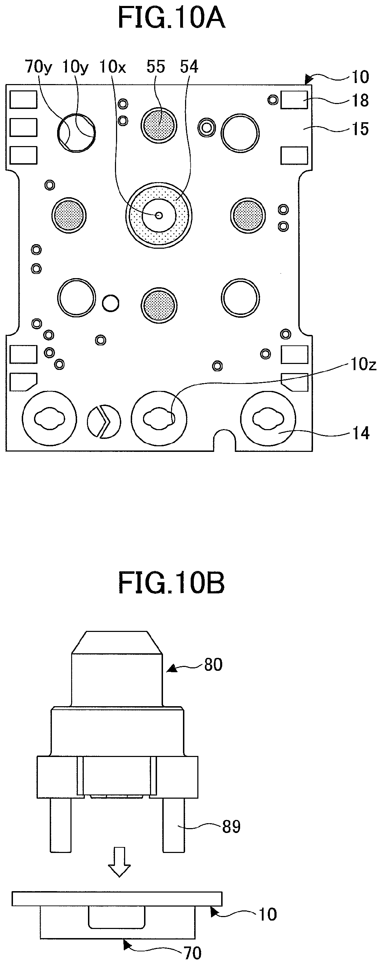

Next, in a process illustrated in FIG. 10A, the adhesive resin for sealing 54 (a first adhesive resin) is applied to the outside of the pressure medium introduction hole 10x on the lower surface of the substrate 10 in a ring shape (for example, a circular ring shape). Also, the nozzle adhesive resin 55 (a second adhesive resin) is applied to the outside of the adhesive resin for sealing 54, in an island configuration (for example, at four places) . Note that pads for testing 18 may be formed on the lower surface of the substrate 10.

The area to which the adhesive resin for sealing 54 and the nozzle adhesive resin 55 are applied is formed, for example, to be concave without forming the solder resist 15, and the adhesive resin for sealing 54 and the nozzle adhesive resin 55 can be applied to the concave portion. However, the adhesive resin for sealing 54 and the nozzle adhesive resin 55 may be applied to a flat portion on the solder resist 15 without forming a concave portion.

As the adhesive resin for sealing 54, a fluorine resin may be used, for example. As the nozzle adhesive resin 55, a silicone resin may be used, for example. A fluorine resin is more suitable than the silicone resin in terms of having a higher reliability for not readily deteriorating, and not readily transmitting the pressure medium (not readily leaking the pressure medium). The silicone resin is more suitable than the fluorine resin in terms of higher adhesion strength. In this way, using multiple sorts of adhesive resins for mounting the nozzle 80 can improve degrees of freedom in design such that resins can be selected so as to secure the adhesion strength between the substrate 10 and the nozzle 80, as well as to have a higher tolerance to a specific pressure medium.

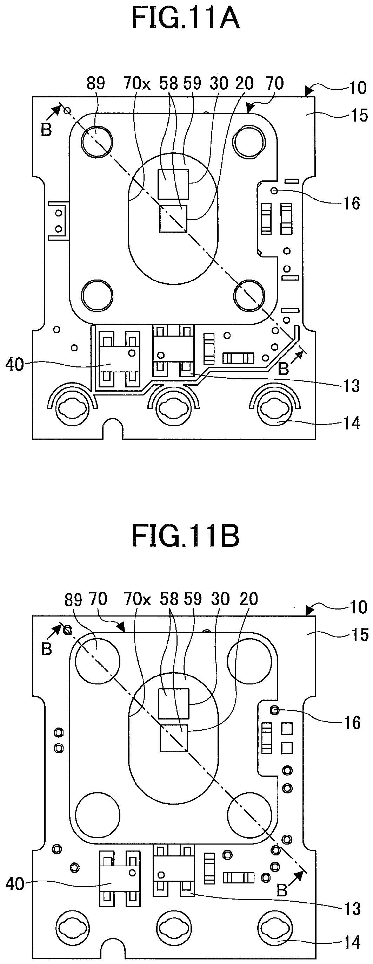

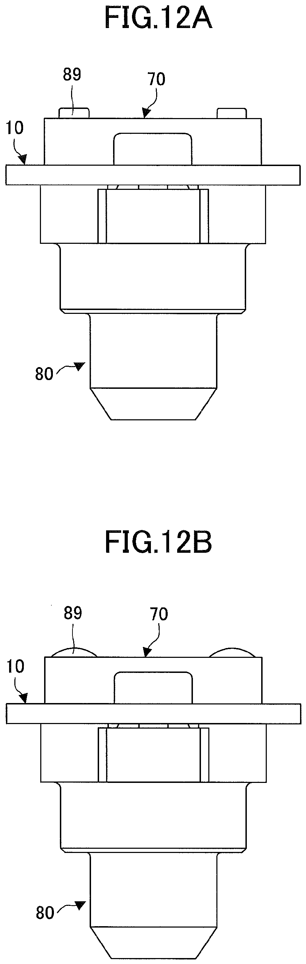

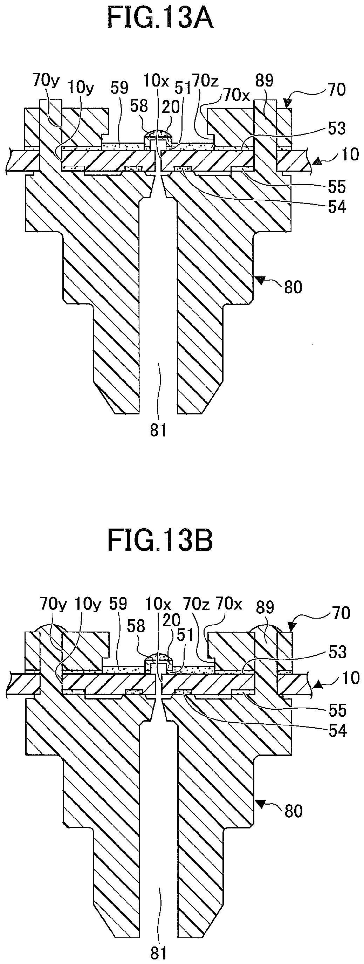

Next, in a process illustrated in FIG. 10B, the nozzle 80 is mounted on the substrate having the cylinder 70 and the like mounted. Specifically, the pillar-shaped positioning parts 89 provided in the nozzle 80 (for example, at four places) are inserted into the positioning holes 10y of the substrate 10 and the positioning holes 70y of the cylinder 70. At this time, as illustrated in FIG. 11A, FIG. 12A, and FIG. 13A, the tips of the positioning parts 89 project out of the upper surface of the cylinder 70. Note that FIG. 11A and FIG. 11B are plan views; FIG. 12A and FIG. 12B are side views; and FIG. 13A and FIG. 13B are cross-sectional views along the line B-B line in FIGs. 11A-11B.

Next, in a process illustrated in FIG. 11A, FIG. 11B, FIG. 12A, FIG. 12B, FIG. 13A, and FIG. 13B, heat welding is executed. Specifically, the tips of the positioning parts 89 are heated to be melted so that the outer edge part of each positioning part 89 is spread in a ring shape around the positioning hole 70y of the upper surface of the cylinder 70. Then, the tips of the positioning parts 89 are hardened so as to have the outer edge parts of the positioning parts 89 joined to the upper surface of the cylinder 70. Thus, the substrate 10 and the cylinder 70 are bonded by the adhesive resin 53, the substrate 10 and the nozzle 80 are bonded by the nozzle adhesive resin 55, and the cylinder 70 and the nozzle 80 are further joined by the heat welding in a state of having the substrate 10 interposed in-between. Therefore, the substrate 10, the cylinder 70, and the nozzle 80 are stuck together tightly, and it is possible to prevent leakage of the pressure medium. Note that the positioning parts 89 of the nozzle 80 and the cylinder 70 may also be melted respectively, and then fixed.

Subsequently, the external terminals 90 are mounted into the respective external terminal insertion holes 10z. Thus, manufacturing the semiconductor sensor device 1 is completed. Note that it is preferable to apply moisture-proof coating so as to cover the part mounting pads 13, the through holes 16, the pads for testing 18, and the mounting parts 40. This is to prevent, for example, corrosion due to factors such as sulfide in an outdoor environment, which may generate disconnection in the through holes 16 and the like.

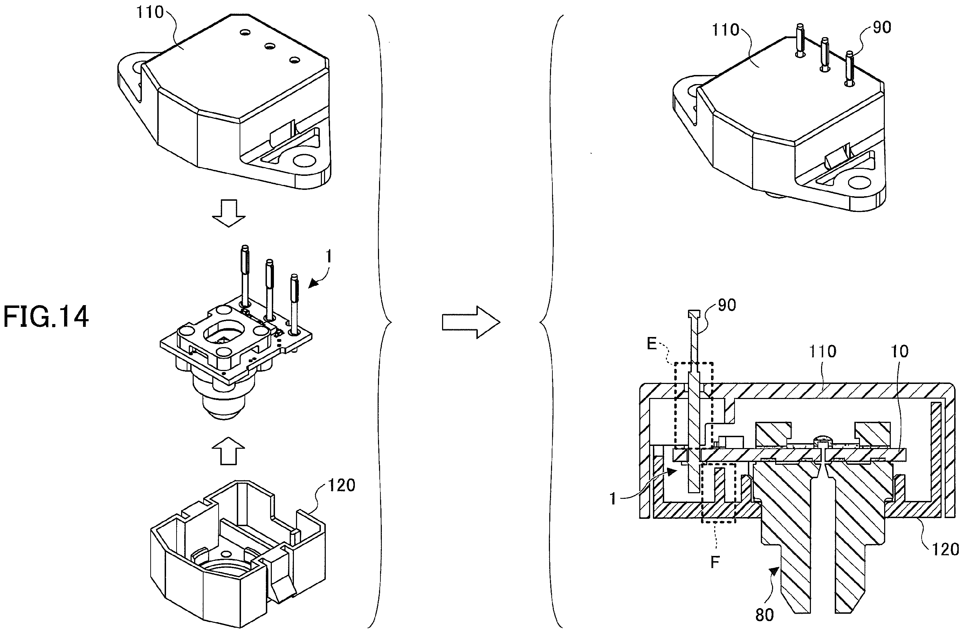

If necessary, as illustrated in FIG. 14, the semiconductor sensor device 1 may be covered by cases 110 and 120 (for example, molding resin products). In the example in FIG. 14, a part of the nozzle 80 of the semiconductor sensor device 1 is exposed out of the case 120. Also, a part of the external terminals 90 of the semiconductor sensor device 1 are exposed out of the case 110.

Note that it is preferable to have the case 110 and the case 120 fitted together to be fixed such that the substrate 10 of the semiconductor sensor device 1 has a structure not to be directly fixed to the cases 110 and 120 (part E in FIG. 14). Such a structure makes it possible to prevent stress generated when assembling the cases 110 and 120 from propagating to the substrate 10, and to be less influenced by stress generated when attaching the assembled cases to another housing. Consequently, it is possible to avoid the stress affecting a characteristic of the semiconductor sensor element 20. Also, it is preferable to provide a part extending toward and abutting the substrate 10 (part E in FIG. 14) in the case 120. This part can control against bend of the substrate 10, which may be generated by the external terminals 90 pushed when forming connections to the external terminals 90.

In this way, the semiconductor sensor device 1 according to the first embodiment mounts all the mounting parts including the semiconductor sensor element 20 on the upper surface or the lower surface of the substrate 10. Also, a glass base is not used for mounting the semiconductor sensor element 20. Also, the nozzle 80 is bonded to the substrate 10 by an adhesive resin, and joined with the cylinder 70 by heat welding in a state of having the substrate interposed in-between. Thus, the semiconductor sensor device 1 is realized having a secured reliability and a reduced manufacturing cost.

### <Modified example of first embodiment>

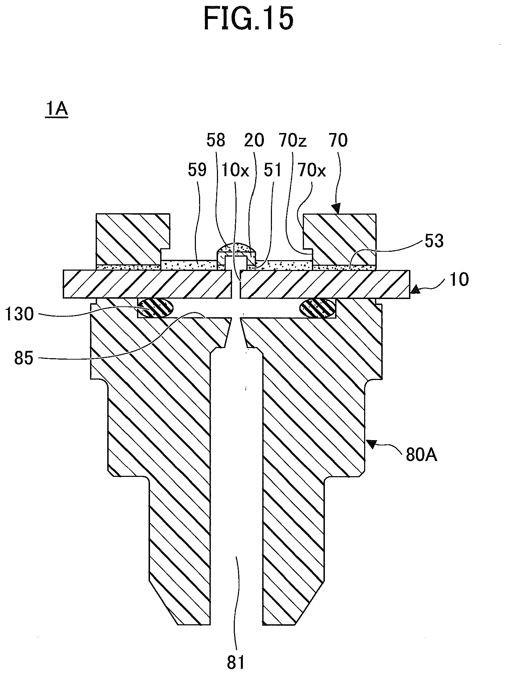

FIG. 15 is a cross-sectional view illustrating a semiconductor sensor device according to a modified example of the first embodiment, specifically illustrating a cross section corresponding to FIG. 3A. In the first embodiment, examples have been described in which the pressure medium is sealed by the adhesive resins 54 and 55; instead, a structure may be adopted in which the pressure medium is sealed by an O-ring 130 as in a semiconductor sensor device 1A illustrated in FIG. 15.

The semiconductor sensor device 1A has an O-ring arrangement part 85 provided in a nozzle 80A. The O-ring 130 placed at the O-ring arrangement part 85 is flattened when heat welding is applied to the cylinder 70 and the nozzle 80A. Therefore, it is possible to stably seal the pressure medium. The other effects are substantially the same as in the first embodiment.

As above, preferable embodiments and a modified example have been described. Note that the present invention is not limited to the above embodiments and the modified example. Various changes and replacements can be made in the above embodiments and the modified example without deviating from the scope of the present invention described in the claims.

### [Description of Reference Symbols]

- 1,: 1A semiconductor sensor device
- 10: substrate
- 10x: pressure medium introduction hole
- 10y: positioning hole
- 10z: external terminal insertion hole
- 11: element installation area
- 11a: surrounding area of pressure medium introduction hole
- 12: bonding pad
- 13: part mounting pad
- 14: external terminal mounting pad
- 15: solder resist
- 15a, 15b: resist spacer
- 16: through hole
- 18: pad for testing
- 20: semiconductor sensor element
- 30: control IC
- 40: mounting part
- 51, 52, and 53: adhesive resin
- 54: the adhesive resin for the seals
- 55: nozzle adhesive resin
- 58: device protection gel
- 59: substrate protection gel
- 60: metal line
- 70: cylinder
- 70x: opening
- 70y: positioning hole
- 70z: stepping part
- 80, 80A: nozzle
- 81: pressure medium introduction hole
- 82: flow restriction part
- 83: buffer part
- 85: O-ring arrangement part
- 89: positioning part
- 90: external terminal
- 110, 120: case
- 130: O-ring

## Claims

1. A semiconductor sensor device (1, 1A), comprising:
a substrate (10);
a semiconductor sensor element (20) mounted on one side of the substrate (10), to detect pressure of a pressure medium,
a protection member (70) mounted on the one side of the substrate (10), to protect the semiconductor sensor element (20); and
a pressure medium introduction member (80) mounted on another side of the substrate (10), to introduce a pressure medium into the semiconductor sensor element (20) via a penetration hole (10x) provided in the substrate (10),
wherein the protection member (70) and the pressure medium introduction member (80) are joined in a state of having the substrate (10) interposed in-between,
the semiconductor sensor device (1, 1A) being **characterized in that**
the pressure medium introduction member (80) includes one or more positioning parts (89),
wherein the positioning part (89) is inserted into a positioning hole (10y) that is continuous through the substrate (10) and the protection member (70), and a tip of the positioning part (89) projects out of a surface of the protection member (70),
wherein the projected part (89) is joined to the surface of the protection member (70) by heat welding.

2. The semiconductor sensor device (1) as claimed in claim 1, wherein the pressure medium introduction member (80) is bonded to the substrate (10) by a first adhesive resin (54) and a second adhesive resin (55),
wherein the first adhesive resin (54) is applied to an outside of the penetration hole (10x) in a ring shape on the other side of the substrate (10),
wherein the second adhesive resin (55) is applied to a further outside with respect to the first adhesive resin (54) applied in the ring shape on the other side of the substrate (10).

3. The semiconductor sensor device (1) as claimed in claim 2, wherein the first adhesive resin (54) is a fluorine resin, and the second adhesive resin (55) is a silicone resin.

4. The semiconductor sensor device (1, 1A) as claimed in claim 1, wherein the pressure medium introduction member (80) includes a pressure medium introduction hole (81),
wherein the pressure medium introduction hole (81) has a first portion having a first cross-sectional area, a second portion (82) having a second cross-sectional area smaller than the first cross-sectional area, and a third portion (83) having a third cross-sectional area larger than the second cross-sectional area,
wherein the first portion is formed at a position away from the substrate (10), the third portion (83) is formed at a position close to the substrate (10), and the second portion (82) is formed between the first portion and the third portion (83).

5. The semiconductor sensor device (1, 1A) as claimed in claim 4, wherein the second cross-sectional area varies depending on a position in the second portion (82), so as to be maximum at a position in the second portion (82) closest to the first portion, and to become smaller at a position in the second portion (82) closer to the third portion (83).

6. The semiconductor sensor device (1, 1A) as claimed in claim 1, wherein all mounting parts (40), consisting of part or all of an IC, a transistor, a resistor, a capacitor, and an inductor, are mounted on the substrate (10).

7. The semiconductor sensor device (1, 1A) as claimed in claim 1, wherein the protection member (70) has an opening (70x),
wherein distances from a center (20c) of the semiconductor sensor element (20) to an inner wall surface of the opening (70x) have a relationship of point symmetry.

8. The semiconductor sensor device (1, 1A) as claimed in claim 1, wherein the pressure medium is a gas.

## Patentansprüche

1. Halbleiter-Sensorvorrichtung (1, 1A), umfassend:
ein Substrat (10);
ein Halbleiter-Sensorelement (20), das auf einer Seite des Substrats (10) montiert ist, um Druck eines Druckmediums zu erfassen,
ein Schutzelement (70), das auf der einen Seite des Substrats (10) montiert ist, um das Halbleiter-Sensorelement (20) zu schützen; und
ein Druckmedium-Einführelement (80), das auf einer anderen Seite des Substrats (10) montiert ist, um ein Druckmedium über ein Durchdringungsloch (10x), das im Substrat (10) vorgesehen ist, in das Halbleiter-Sensorelement (20) einzuführen,
wobei das Schutzelement (70) und das Druckmedium-Einführelement (80) in einem Zustand, in dem sie das Substrat (10) dazwischen eingefügt aufweisen, verbunden sind,
wobei die Halbleiter-Sensorvorrichtung (1, 1A) **dadurch gekennzeichnet ist, dass**
das Druckmedium-Einführelement (80) einen oder mehrere Positionierungsteile (89) umfasst,
wobei der Positionierungsteil (89) in ein Positionierungsloch (10y) eingeführt wird, das durch das Substrat (10) und das Schutzelement (70) durchgehend ist, und eine Spitze des Positionierungsteils (89) von einer Oberfläche des Schutzelements (70) vorsteht,
wobei der vorstehende Teil (89) durch Heißverschweißen mit der Oberfläche des Schutzelements (70) verbunden ist.

2. Halbleiter-Sensorvorrichtung (1) nach Anspruch 1, wobei das Druckmedium-Einführelement (80) durch ein erstes Klebeharz (54) und ein zweites Klebeharz (55) an das Substrat (10) gebondet ist,
wobei das erste Klebeharz (54) auf eine Außenseite des Durchdringungslochs (10x) in einer Ringform auf der anderen Seite des Substrats (10) aufgetragen ist,
wobei das zweite Klebeharz (55) auf eine weitere Außenseite in Bezug auf das in der Ringform auf die andere Seite des Substrats (10) aufgetragene erste Klebeharz (54) aufgetragen ist.

3. Halbleiter-Sensorvorrichtung (1) nach Anspruch 2, wobei das erste Klebeharz (54) ein Fluorharz ist, und das zweite Klebeharz (55) ein Silikonharz ist.

4. Halbleiter-Sensorvorrichtung (1, 1A) nach Anspruch 1, wobei das Druckmedium-Einführelement (80) ein Druckmedium-Einführloch (81) umfasst,
wobei das Druckmedium-Einführloch (81) einen ersten Abschnitt mit einem ersten Querschnittsfläche, einen zweiten Abschnitt (82) mit einer zweiten Querschnittsfläche, die kleiner als die erste Querschnittsfläche ist, und einen dritten Abschnitt (83) mit einer dritten Querschnittsfläche aufweist, die größer als die zweite Querschnittsfläche ist,
wobei der erste Abschnitt in einer Position entfernt vom Substrat (10) ausgebildet ist, der dritte Abschnitt (83) in einer Position nahe zum Substrat (10) ausgebildet ist, und der zweite Abschnitt (82) zwischen dem ersten Abschnitt und dem dritten Abschnitt (83) ausgebildet ist.

5. Halbleiter-Sensorvorrichtung (1, 1A) nach Anspruch 4, wobei die zweite Querschnittsfläche in Abhängigkeit von einer Position im zweiten Abschnitt (82) variiert, so dass sie in einer Position im zweiten Abschnitt (82) am nächsten zum ersten Abschnitt am größten ist, und in einer Position im zweiten Abschnitt (82) näher zum dritten Abschnitt (83) kleiner wird.

6. Halbleiter-Sensorvorrichtung (1, 1A) nach Anspruch 1, wobei alle Montageteile (40), die aus einem Teil oder der Gesamtheit einer IC, eines Transistors, eines Widerstands, eines Kondensators und eines Induktors bestehen, auf dem Substrat (10) montiert sind.

7. Halbleiter-Sensorvorrichtung (1, 1A) nach Anspruch 1, wobei das Schutzelement (70) eine Öffnung (70x) aufweist,
wobei Distanzen von einer Mitte (20c) des Halbleiter-Sensorelements (20) zu einer Innenwandfläche der Öffnung (70x) eine Punktsymmetriebeziehung haben.

8. Halbleiter-Sensorvorrichtung (1, 1A) nach Anspruch 1, wobei das Druckmedium ein Gas ist.

## Revendications

1. Dispositif de capteur à semi-conducteur (1, 1A) comprenant :
un substrat (10) ;
un élément capteur à semi-conducteur (20) monté sur un côté du substrat (10) pour détecter la pression d'un milieu sous pression,
un élément de protection (70) monté sur le côté susdit du substrat (10) pour protéger l'élément capteur à semi-conducteur (20) ; et
un élément d'introduction de milieu sous pression (80) monté sur un autre côté du substrat (10) pour introduire un milieu sous pression dans l'élément capteur à semi-conducteur (20) via un trou de pénétration (10x) prévu dans le substrat (10),
dans lequel l'élément de protection (70) et l'élément d'introduction de milieu sous pression (80) sont joints dans un état où le substrat (10) est interposé entre eux,
le dispositif de capteur à semi-conducteur (1, 1A) étant **caractérisé en ce que**
l'élément d'introduction de milieu sous pression (80) comprend une ou plusieurs pièces de positionnement (89),
dans lequel la pièce de positionnement (89) est insérée dans un trou de positionnement (10y) qui est continu à travers le substrat (10) et l'élément de protection (70), et une pointe de la pièce de positionnement (89) fait saillie hors d'une surface de l'élément de protection (70),
dans lequel la pièce en saillie (89) est jointe à la surface de l'élément de protection (70) par soudage à chaud.

2. Dispositif de capteur à semi-conducteur (1) selon la revendication 1, dans lequel l'élément d'introduction de milieu sous pression (80) est collé au substrat (10) par une première résine adhésive (54) et une deuxième résine adhésive (55),
dans lequel la première résine adhésive (54) est appliquée à l'extérieur du trou de pénétration (10x) sous une forme annulaire sur l'autre côté du substrat (10),
dans lequel la deuxième résine adhésive (55) est appliquée encore plus à l'extérieur par rapport à la première résine adhésive (54) appliquée sous forme annulaire sur l'autre côté du substrat (10).

3. Dispositif de capteur à semi-conducteur (1) selon la revendication 2, dans lequel la première résine adhésive (54) est une résine fluorée, et la deuxième résine adhésive (55) est une résine siliconée.

4. Dispositif de capteur à semi-conducteur (1, 1A) selon la revendication 1, dans lequel l'élément d'introduction de milieu sous pression (80) comprend un trou d'introduction de milieu sous pression (81),
dans lequel le trou d'introduction de milieu sous pression (81) a une première partie ayant une première superficie en coupe transversale, une deuxième partie (82) ayant une deuxième superficie en coupe transversale inférieure à la première superficie en coupe transversale, et une troisième partie (83) ayant une troisième superficie en coupe transversale supérieure à la deuxième superficie en coupe transversale,
dans lequel la première partie est formée en une position à distance du substrat (10), la troisième partie (83) est formée en une position proche du substrat (10), et la deuxième partie (82) est formée entre la première partie et la troisième partie (83).

5. Dispositif de capteur à semi-conducteur (1, 1A) selon la revendication 4, dans lequel la deuxième superficie en coupe transversale varie en fonction de la position dans la deuxième partie (82), de façon à être maximale en une position dans la deuxième partie (82) la plus proche de la première partie, et à devenir plus petite en une position dans la deuxième partie (82) plus proche de la troisième partie (83).

6. Dispositif de capteur à semi-conducteur (1, 1A) selon la revendication 1, dans lequel toutes les pièces de montage (40) consistant, en totalité ou en partie, en un CI, un transistor, une résistance, un condensateur, et un inducteur, sont montées sur le substrat (10).

7. Dispositif de capteur à semi-conducteur (1, 1A) selon la revendication 1, dans lequel l'élément de protection (70) a une ouverture (70x),
dans lequel les distances entre un centre (20c) de l'élément capteur à semi-conducteur (20) et une surface de paroi intérieure de l'ouverture (70x) ont une relation de symétrie ponctuelle.

8. Dispositif de capteur à semi-conducteur (1, 1A) selon la revendication 1, dans lequel le milieu sous pression est un gaz.
